# EUROPÄISCHE PATENTSCHRIFT

(11) **EP 2 273 567 B1**
(45) Veröffentlichungstag und Bekanntmachung des Hinweises auf die Patenterteilung: **21.08.2013**
(21) Anmeldenummer: 09008542.4
(22) Anmeldetag: 30.06.2009
(51) Int. Cl.: H01L 31/18, B21F 1/02, B23K 3/08

(54) **Verfahren und Vorrichtung zum Recken von Lötband**
Method and device for stretching solder wire
Procédé et dispositif destinés à la tension d'une bande de soudage

(43) Veröffentlichungstag der Anmeldung: 12.01.2011
(73) Patentinhaber: Mikron Berlin GmbH, 12623 Berlin (DE)
(72) Erfinder: Nowak, Andreas, 16341 Panketal (DE)
(74) Vertreter: Hannig, Wolf-Dieter

(56) Entgegenhaltungen:
- EP-A2- 1 089 347
- JP-A- 5 315 206
- JP-A- 2005 235 971
- JP-A- 2008 284 560
- US-A- 4 534 502

## Beschreibung

Die Erfindung betrifft Verfahren zum Recken eines Lötband, insbesondere Lötverbinder (Ribbon) für Solarzellen, bei dem ein auf einer Haspeleinrichtung bevorratetes dünnes Lötband abgewickelt, gereckt und einer Schneideinrichtung zum Ablängen der Lötverbinder zugeführt wird.

Die Erfindung betrifft ferner Vorrichtungen zur Durchführung der Verfahren, mit einer Haspeleinrichtung zum Auf- und Abwickeln von Lötband, einer Greifereinrichtung zum Greifen des Lötbandes und einer Schneideinrichtung zum Ablängen von Lötverbindern vom Lötband.

### Stand der Technik

Aus der DE 10 2006 006 715 A1 ist eine Vorrichtung und ein Verfahren zum Ausrichten und Befestigen eines Bandes an einer Solarzelle bekannt, die einen vorderen und hinteren Arm, die beweglich an einer linearen Führung angebracht sind, Bewegungsmittel für eine Aufwärts- und Abwärtsbewegung der linearen Führungen, Scherenmittel zum Durchschneiden des Bandes, wobei der vordere und hintere Arm jeweils mindestens ein Greifermittel zum Ergreifen des Bandes umfassen, wobei die Greifermittel vorgesehen sind, um das Band mit einer vorgegebenen Längsspannung zu beaufschlagen. Das bekannte Verfahren läuft so ab, dass der Greifer des vorderen Armes das Band zu einer vorgegebenen Position, der hintere Arm zu einer anderen vorgegebenen Position bewegt wird, wobei das Greifermittel des hinteren Armes geöffnet wird, und das Greifmittel des hinteren Armes erneut geschlossen wird, wobei das Band durch Aufbringen einer vorgegebenen Längsspannung auf das Band gestrafft wird. Es folgt ein Absenken des Greifermittels auf die Ebene einer Solarzelle, die unter dem Band positioniert ist. Nachdem das Band mit der Solarzelle durch Aufbringen von Wärme auf das Band, vorzugsweise Laserstrahlung, verbunden ist, wird das Band mittels Scherenmittel durchgeschnitten. Das Greifermittel des vorderen Arms wird dann geöffnet, so dass das Band und die Solarzelle weitertransportiert werden können.
Von Nachteil ist jedoch, dass das beiderseitige Ergreifen der Enden des Bandes einem kontinuierlichen Fertigungsprozess außerordentlich hinderlich ist und einen erheblichen konstruktiven und technologischen Aufwand nach sich zieht. Außerdem arbeitet dieser bekannte Stand der Technik mit einem Recken über eine fest vorgegebene Längsspannung, so dass bereits geringfügige Änderungen in den Bandabmessungen zu Überdehnungen, d.h. zum Überschreiten der Fließgrenze des Bandes führen können. Eine ständige Nachregelung der Parameter in Abhängigkeit der Änderung der Bandmessungen offenbart dieser bekannte Stand der Technik nicht.

Aus der WO 03/059570 A1 ist des Weiteren eine Streifenschneid- und Falzstation zum Schneiden und Falzen von Lötband bekannt, bei der das Schneiden ohne jegliche Vorspannung durchgeführt wird, wodurch entsprechende Qualitätseinbußen an den Lötverbindern hingenommen werden müssen.

Die US 5 534 502 A beschreibt eine Einrichtung und ein Verfahren zur Anwendung mindestens eines gereckten Verbinders auf eine Vielzahl von Solarzellen, um die elektrische Verbindung zwischen den Zellen herzustellen.

### Aufgabenstellung

Bei diesem Stand der Technik liegt der Erfindung die Aufgabe zugrunde, ein Verfahren und eine Vorrichtung zum Recken von Lötband, insbesondere Lötverbinder für Solarzellen, bereitzustellen, das bzw. die es ermöglicht, das Lötband exakt bis zur Fließgrenze unter gleichzeitiger Vereinfachung des Prozesses und Einsparung von Kosten zu belasten.

Diese Aufgabe wird durch ein Verfahren der eingangs genannten Gattung mit den Merkmalen des Anspruchs 1 und durch eine Vorrichtung mit den Merkmalen des Ansprüchs 9 gelöst.

Vorteilhafte Ausgestaltungen der erfindungsgemäßen Verfahren und der erfindungsgemäßen Vorrichtungen sind den Unteransprüchen entnehmbar

Der erfindungsgemäßen Lösung liegt die Erkenntnis zugrunde, während des Reckvorgangs permanent die Zugkraft des Lötbandes durch eine Messeinrichtung zu ermitteln und durch einen Rechner mit den ermittelten Messwerten eine in einer Bremseinrichtung erzeugte Gegenkraft kontinuierlich auf einen vorgegebenen Sollwert abzugleichen, der etwa oder exakt der Fließgrenze des Lötbandes entspricht.

Dies wird durch folgende Schritte erreicht:
a) Ausbilden eines Bandpuffers in Form einer Schlaufe des abgewickelten Bandes,
b) Ergreifen des Bandes aus dem Puffer an einem Ende und Ziehen des Bandendes mit einer vorgegebenen Zugkraft durch die von einer Vorschubeinheit in Bandlaufrichtung verfahrbare Greifeinrichtung bis zu einer Endposition entgegen einer durch die Bremseinrichtung auf das Band aufgebrachten Gegenkraft,
c) kontinuierliches Messen der Zugkraft während des Ziehens nach Schritt b) mit einer Kraftmesseinrichtung,
d) Weiterleitung der Messwerte an einen Rechner zur Auswertung der Zugkraft und permanentes Einregeln der Bremseinrichtung auf den vorwählbaren Sollwert der Gegenkraft während des Verfahrens der Greifeinrichtung,
e) Klemmen des Bandes mit einer Klemmeinrichtung, sobald die Greifeinrichtung ihre Endposition erreicht hat,
f) Abtrennen der Lötverbinder durch Schneiden des Bandes mit der Schneideinrichtung, wobei zeitgleich der Bandpuffer gemäß Schritt a) aufgefüllt wird und Wiederholen der Schritte b) bis f).

Nach einer bevorzugten weiteren Ausgestaltung des erfindungsgemäßen Verfahrens ist durch die Wahl der Endposition der Greifeinrichtung in der Vorschubeinheit die Länge der Lötverbinder frei regelbar.

Eine weitere vorteilhafte Ausführungsform des erfindungsgemäßen Verfahrens sieht vor, dass der Sollwert der Gegenkraft der Bremseinrichtung über den Rechner frei einstellbar ist.

Die Erfindung geht weiterhin von der Erkenntnis aus, dass das Lötband an einer Position geklemmt und durch Ziehen des Lötbandes gegen die geklemmte Position unter permanenter Messung der Streckkraft solange gereckt wird, bis ein der Fließgrenze des Lötbandes entsprechender Sollwert erreicht wird, wobei die Messwerte einem Rechner zugeführt werden, der die Messwerte mit einem der Fließgrenze entsprechenden Sollwert vergleicht und bei Erreichen des Sollwertes die Schneideinrichtung zum Abtrennen des Lötverbinders ansteuert.

Das erfindungsgemäße Verfahren wird bei dieser Variante mit folgenden Schritten durchgeführt:
a) Ausbilden eines Bandpuffers in Form einer Schlaufe des abgewickelten Bandes,
b) Ergreifen des Bandes aus dem Bandpuffer durch die Greifeinrichtung und Bewegen des Bandes bis zu einer vorgewählten Länge des Lötverbinders,
c) Klemmen des Bandes mit einer Klemmeinrichtung, sobald die Greifeinrichtung die vorgewählte Länge erreicht hat,
d) Ziehen des geklemmten Lötbandes in Richtung einer von der Vorschubeinheit vorgegebenen Endposition mit der Greifeinrichtung bis der Sollwert eine vorgegebene Streckkraft durch ein kontinuierliches Messen der Zugkraft während des Ziehens mit einer Kraftmesseinrichtung detektiert wird,
e) Weiterleitung der Messwerte an einen Rechner zur Auswertung der Streckkraft und Ansteuern der Schneideinrichtung,
f) Abtrennen der Lötverbinder durch Schneiden des Bandes mit der Schneideinrichtung, wobei zeitgleich der Bandpuffer gemäß Schritt a) aufgefüllt wird und Wiederholen der Schritte b) bis f).

In bevorzugter weiterer Ausgestaltung des erfindungsgemäßen Verfahrens wird die Schlaufe durch eine senkrecht zur Vorschubrichtung des Bandes selbsttätig verfahrbare Abzugseinrichtung oder durch eine senkrecht zur Vorschubrichtung des Bandes wirkende Masse einer Tensoreinrichtung entgegen einer auf das Band einwirkenden Bremskraft gebildet, die in Abhängigkeit einer Minimal- oder Maximallage der Schlaufe zu- oder abgeschaltet wird.

Die Aufgabe der Erfindung wird weiterhin durch eine erfindungsgemäße Vorrichtung dadurch gelöst, dass eine als Bandpuffer bzw. Schlaufe ausgebildete, senkrecht zur Bandlaufrichtung verfahrbare Abzugs- oder Tensoreinrichtung vorgesehen ist, der eine Bremseinrichtung zum Aufbringen einer Brems- bzw. Gegenkraft auf das Lötband, eine Klemmeinrichtung zum Festhalten des Lötbandes, die Schneideinrichtung zum Durchtrennen des Lötbandes und die auf einer Vorschubeinheit parallel zum Bandlauf verfahrbare Greifeinrichtung zur Ziehen des Lötbandes aus einer der Schneideinrichtung zugeordneten Position in eine die Länge der Lötverbinder bestimmende Endposition nachgeordnet sind, wobei die Greifeinrichtung mit einer Messeinrichtung zum Ermitteln einer zwischen Bremseinrichtung und Greifeinrichtung wirkenden Zugkraft versehen ist, die mit einem Rechner zum Ansteuern der Bremseinrichtung zwecks Abgleichung der Gegenkraft an einen vorgegebenen Sollwert der Zugkraft einen Regelkreis bildet.

Von besonderer Bedeutung bei einer vorteilhaften Ausgestaltung der erfindungsgemäßen Vorrichtung ist, dass die Bremseinrichtung zueinander anstellbare Rollen aufweist, wodurch die Gegenkraft im Regelkreis frei wählbar eingestellt werden kann.

In weiterer bevorzugter Ausgestaltung der erfindungsgemäßen Vorrichtung umfasst die Abzugseinrichtung eine durch einen Linearantrieb senkrecht zur Bandlaufrichtung verfahrbare Umlenkrolle zum Ausbilden der Bandschlaufe und stationäre Umlenkrollen zum Umlenken des Lötbandes. Anstelle der Abzugseinrichtung kann aber auch eine Tensoreinrichtung vorgesehen werden, die die Schlaufe allein durch eine senkrecht zur Vorschubeinrichtung wirkende Masse einer Tensorrolle und einer auf das Band einwirkenden Bremse bildet, wobei der Bremse Sensoren zugeordnet sind, die Signale für eine Minimal- oder Maximallage der Schlaufe einem Steuerorgan zuführen, das die Bremse zu- oder abschaltet.

In weiterer Ausgestaltung der Erfindung ist vorgesehen, dass eine als Bandpuffer bzw. Schlaufe ausgebildete, senkrecht zur Bandlaufrichtung verfahrbare Abzugs- oder Tensoreinrichtung vorgesehen ist, der eine Bremseinrichtung zum Aufbringen einer Bremskraft auf das Lötband, eine Klemmeinrichtung zum Festhalten des Lötbandes, die Schneideinrichtung zum Durchtrennen des Lötbandes und die auf einer Vorschubeinheit parallel zum Bandlauf verfahrbare Greifeinrichtung zum Ziehen des Lötbandes aus einer der Schneideinrichtung zugeordneten Position in eine die Länge der Lötverbinder bestimmende Endposition nachgeordnet sind, wobei die Greifeinrichtung mit einer Messeinrichtung zum Ermitteln einer zwischen Klemmeinrichtung und Greifeinrichtung wirkenden Streckkraft versehen ist, die mit einem Rechner zum Ansteuern der Klemmeinrichtung zwecks Abgleichung der Zugkraft an einen vorgegebenen Sollwert der Streckkraft einen Regelkreis bildet.

Nach einer weiteren vorteilhaften Ausgestaltung der erfindungsgemäßen Vorrichtung ist der Antrieb für die Puffereinrichtung und die Vorschubeinheit der Greifeinrichtung ein Linearantrieb.

In einer weiteren bevorzugten Ausführungsform der erfindungsgemäßen Vorrichtung ist die Messeinrichtung an der Greifeinrichtung eine Kraftmessdose.

Weitere Vorteile und Einzelheiten der Erfindung ergeben sich aus der nachfolgenden Beschreibung unter Bezugnahme auf die beigefügten Zeichnungen.

### Ausführungsbeispiel

Die Erfindung soll nachstehend an zwei Ausführungsbeispielen näher erläutert werden.

### Es zeigt

Fig. 1 ein Schema des Aufbau der erfindungsgemäßen Vorrichtung zur Ausführung des erfindungsgemäßen Verfahrens in einer ersten Ausführungsvariante und

Fig. 2 ein Schema des Aufbaus der erfindungsgemäßen Vorrichtung zur Ausführung des erfindungsgemäßen Verfahrens in der ersten Ausführungsvariante mit einer Tensoreinrichtung,

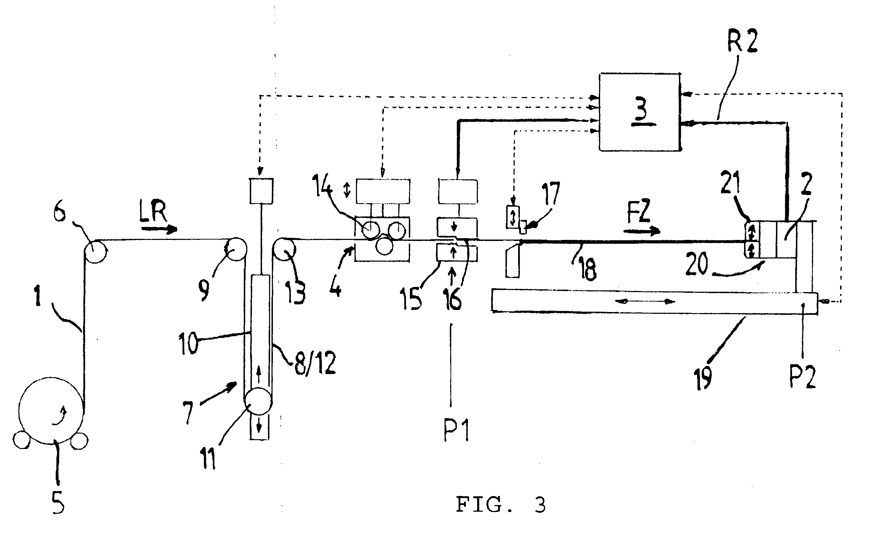

Fig. 3 ein Schema des Aufbaus einer weiteren erfindungsgemäßen Vorrichtung zur Ausführung des erfindungsgemäßen Verfahrens in einer zweiten Ausführungsvariante.

### Beispiel 1

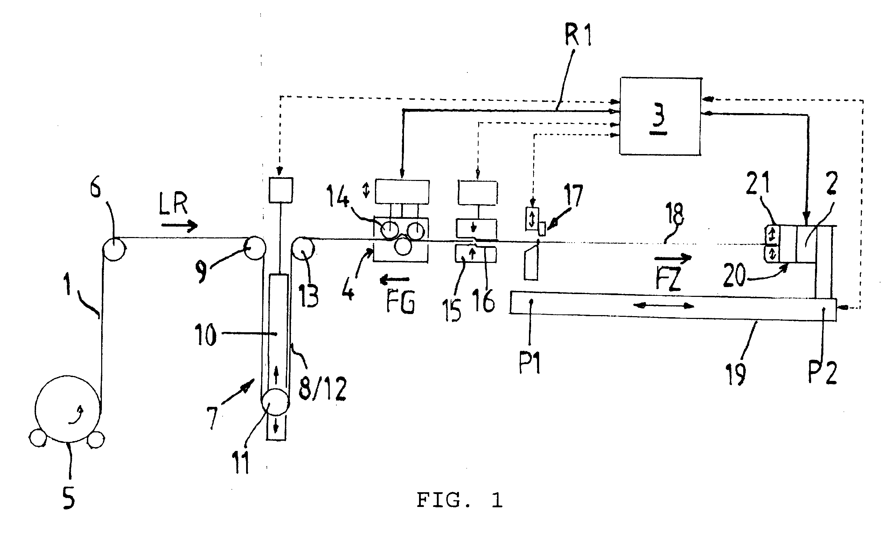

Die Fig. 1 zeigt ein Schema des erfindungsgemäßen Verfahrens, welches permanent die Zugkraft FZ des Lötbandes 1 während des Reckvorgangs durch eine Messeinrichtung 2 ermittelt und durch einen Rechner 3 mit den ermittelten Messwerten eine in einer Bremseinrichtung 4 erzeugte Gegenkraft FG kontinuierlich auf einen vorgegebenen Sollwert abgleicht, der etwa oder exakt auf die Fließgrenze der Materialart des Lötbandes eingestellt wird.

Auf einer Haspeleinrichtung 5 ist das dünne vorverzinnte Lötband 1, beispielsweise aus Kupfer, aufgehaspelt, das von einer Abzugseinrichtung 7 über eine erste Umlenkrolle 6 in einen Bandpuffer 8 abgezogen wird. Die Abzugseinrichtung 7 umfasst eine Umlenkrolle 9 zum Umlenken des Lötbandes 1 in eine senkrecht zur Laufrichtung LR des Lötbandes 1 verlaufende Richtung. In der Abzugseinrichtung 7 ist eine weitere durch einen Linearantrieb 10 senkrecht zur Laufrichtung LR des Lötbandes 1 verfahrbare Umlenkrolle 11 angeordnet, die das Lötband 1 um 180° unter Bildung einer Schlaufe 12, d.h. den Bandpuffer 8, umlenkt. Das Lötband 1 verlässt den Bandpuffer 8 nach einer neuerlichen Umlenkung des Lötbandes 1 an einer weiteren Umlenkrolle 13, die in Flucht zur Laufrichtung des Lötbandes vorgesehen ist.

Das Lötband 1 bewegt sich sodann durch die Bremseinrichtung 4, die mehrere durch einen Antrieb aufeinander zustellbare Rollen 14 aufweist, mit denen je nach Zustellung der Rollen eine entsprechende Brems- bzw. Gegenkraft FG auf das Lötband 1 aufbringbar ist.

Unmittelbar nach der Bremseinrichtung 4 ist eine Klemmeinrichtung 15 angeordnet, mit deren Hilfe das Lötband 1 fixiert werden kann. Dies geschieht durch gegeneinander verfahrbare Klemmbacken 16, die von einem nicht dargestellten Antrieb betätigt werden.

Mit der der Klemmeinrichtung 15 nachgeschalteten Schneideinrichtung 17 wird vom fixierten Lötband 1 ein Lötverbinder 18 entsprechender Länge abgetrennt.
Unterhalb der Schneideinrichtung 17 befindet sich eine parallel zur Bandlaufrichtung LR des Lötbandes 1 angeordnete Vorschubeinheit 19, die eine Greifeinrichtung 20 in und entgegen der Landlaufrichtung LR verfährt. Der Greifkopf 21 der Greifeinrichtung 20 befindet sich in Flucht des Lötbandes 1, so dass dieser das Lötband 1 ergreifen kann. Die Greifeinrichtung 20 wird durch die Vorschubeinheit 19 bewegt.

Das erfindungsgemäße Verfahren läuft wie folgt ab. Das Lötband 1 wird zunächst durch die Abzugseinrichtung 7 unter Bildung einer Schlaufe 12 von der Haspeleinrichtung 5 abgezogen und nach Passieren der Bremseinrichtung 4 und der Klemmeinrichtung 15 vom Greifkopf 21 der Greifeinrichtung 20 ergriffen, der von der Vorschubeinheit 19 in eine der Schneideinrichtung 17 zugeordnete Position P1 bewegt wurde. Nach dem Greifen des Endes des Lötbandes 1 verfährt die Greifeinrichtung 20 mit Greifkopf 21 in Bandlaufrichtung LR bis in eine Endposition P2.

Am Greifkopf 21 ist eine Messeinrichtung 2, beispielsweise eine Kraftmessdose, zum Messen der von der Greifeinrichtung 20 auf das Lötband 1 aufgebrachten Zugkraft FZ, befestigt. Die Messeinrichtung 2 ist mit dem Rechner 3 verbunden, der seinerseits den Antrieb der Bremseinrichtung 4 zur Erzeugung einer Gegenkraft FG ansteuert. Die Messeinrichtung 2, der Rechner 3 und die Bremseinrichtung 4 bilden einen Regelkreis R1.
Während des Ziehens des Lötbandes 1 in Richtung der Endposition P2 wird die Zugkraft FZ permanent durch die Messeinrichtung 2 gemessen und die Messwerte werden an den Rechner 3 weitergeleitet, der die Messwerte mit einem vorgegebenen Sollwert vergleicht und die von der Bremseinrichtung 4 erzeugte Gegenkraft FG durch Zustellung der Rollen 14 der Bremseinrichtung 4 ständig an den Sollwert anpasst. Dieser Sollwert wird entsprechend der Materialart des Lötbandes so gewählt, dass dieser etwa exakt der Fließgrenze entspricht oder etwas geringer als die Fließgrenze des Materials ist.

Nachdem die Greifeinrichtung 20 die Endposition P2 erreicht hat, veranlasst der Rechner 3 das Schließen der Klemmeinrichtung 15 zum Fixieren des Lötbandes 1 und das Betätigen der Schneideinrichtung 17 zum Abtrennen des Lötverbinders 18 vom Lötband 1.
Zeitgleich zum Schließen der Klemmeinrichtung 15, d.h. während des Verfahrens der Greifeinrichtung 20 bis zu ihrer Endposition P2 steuert der Rechner 3 den Linearantrieb 10 der Abzugseinrichtung 7 zur Bildung der Schlaufe 12 bzw. zum Auffüllen des Bandpuffers an. Ist das Durchtrennen des Lötbandes 1 beendet, erfolgt die Entnahme des Lötverbinders 18 durch nicht dargestellte Entnahmemittel zur weiteren Konfektionierung der Solarzellen
Der Rechner 3 steuert die Greifeinrichtung 20 an, die entgegen der Bandlaufrichtung LR auf der Vorschubeinheit 19 wiederum in die Position P1 verfährt und das Ende des von der Klemmeinrichtung 15 noch geklemmten Lötbandes 1 ergreift. Die Öffnung der Klemmeinrichtung 15 wird durch den Rechner 3 ausgelöst und der Linearantrieb 10 der Abzugseinrichtung 7 abgeschaltet.
Das Verfahren des Greifkopfes 21 der Greifeinrichtung 20 in Richtung Endposition P2 zum Ablängen eines weiteren Lötverbinders 19 kann beginnen.

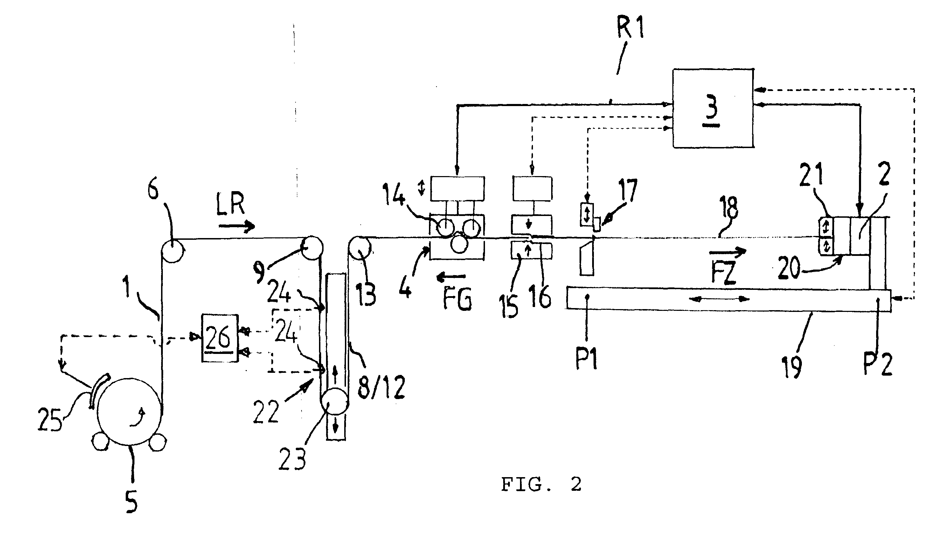

Anstelle der Abzugseinrichtung 7 kann wie Fig. 2 zeigt auch eine Tensoreinrichtung 22 eingesetzt werden. Die Tensoreinrichtung 22 besteht aus einer Tensorrolle 23, die allein durch ihre Masse auf Grund der Schwerkraft eine Abwärtsbewegung ausführt und das Lötband 1 zur Bildung der Schlaufe 12 von der Haspeleinrichtung 5 abzieht. Im Bandpuffer 8 sind zwei dem Lötband 1 zugeordnete Sensoren 24 vorgesehen, die die Lage der Schlaufee zwischen einer Minimal- und Maximallage detektieren. Die Sensoren 24 liefern Signale, die einer Steuereinheit 25 zum Zu- oder Abschalten einer Bremse 26 zugeführt werden, um ein Nachlaufen der Tensorrolle 23 auszuschließen.

### Beispiel 2

Die Fig. 2 zeigt eine weitere Ausführungsvariante des erfindungsgemäßen Verfahrens, die sich gegenüber dem Beispiel 1 dadurch unterscheidet, dass der Ablängvorgang des Lötverbinders 18 nicht innerhalb des Regelkreises erfolgt. Dies geschieht dadurch, dass das Lötband an einer Position P1 geklemmt und an anderer Position P2 durch Verfahren des Lötbandes gegen die geklemmte Position unter permanenter Messung der Streckkraft solange gereckt wird, bis ein der Fließgrenze des Lötbandes entsprechender Sollwert erreicht wird, wobei die Messwerte einem Rechner zugeführt, der die Messwerte mit einem der Fließgrenze entsprechenden Sollwert vergleicht und bei Erreichen des Sollwertes die Schneideinrichtung zum Abtrennen des Lötverbinders ansteuert. Die Messeinrichtung 2, der Rechner 3 und die Klemmeinrichtung 4 bilden einen Regelkreis R2.

An der Greifeinrichtung 20 ist die Messeinrichtung 2 zum Ermitteln der zwischen der Klemmeinrichtung 15 und der Greifeinrichtung 20 wirkenden Streckkraft befestigt. Die Messeinrichtung 2 leitet die Messwerte der ermittelten Zugkraft FZ an den Rechner 3 weiter, der die Messwerte mit einer vorgegebenen Streckkraft vergleicht und veranlasst, dass die Greifeinrichtung 20 über einen entsprechende Antrieb solange verfahren wird, bis die ermittelte Zugkraft mit der vorgegebenen Streckkraft übereinstimmt.
Der weitere Ablauf entspricht dem des Beispiels 1.

### Bezugszeichenliste

- Lötband: 1
- Messeinrichtung: 2
- Rechner: 3
- Bremseinrichtung: 4
- Haspeleinrichtung: 5
- Umlenkrolle: 6
- Abzugseinrichtung: 7
- Bandpuffer: 8
- Umlenkrolle: 9
- Linearantrieb: 10
- Umlenkrolle: 11
- Schlaufe: 12
- Umlenkrolle: 13
- Zustellbare Bremsrollen: 14
- Klemmeinrichtung: 15
- Klemmbacken von 15: 16
- Schneideinrichtung: 17
- Lötverbinder: 18
- Vorschubeinheit: 19
- Greifeinrichtung: 20
- Greifkopf: 21
- Tensoreinrichtung: 22
- Tensorrolle: 23
- Sensoren: 24
- Bremse für 5: 25
- Steuerorgan für 25: 26
- Brems- bzw. Gegenkraft: FG
- Zugkraft: FZ
- Laufrichtung Lötband 1: LR
- Position: P1
- Endposition: P2
- Regelkreis: R1, R2

## Patentansprüche

1. Verfahren zum Recken eines Lötbandes, insbesondere Lötverbinder (18) für Solarzellen, bei dem ein auf einer Haspeleinrichtung (5) bevorratetes dünnes Lötband (1) abgewickelt, gereckt und einer Schneideinrichtung (17) zum Ablängen der Lötverbinder (18) zugeführt wird, **dadurch gekennzeichnet, dass** während des Reckvorgangs permanent die Zugkraft (FZ) des Lötbandes (1) durch eine Messeinrichtung (2) ermittelt und durch einen Rechner (3) mit den ermittelten Messwerten eine in einer Bremseinrichtung (4) erzeugte Gegenkraft (FG) kontinuierlich auf einen vorgegebenen Sollwert der Zugkraft (FZ) abgeglichen wird, der etwa oder exakt auf die Fließgrenze der Materialart des Lötbandes (1) eingestellt wird.

2. Verfahren nach Anspruch 1, **gekennzeichnet durch** folgende Schritte:
a) Ausbilden eines Bandpuffers (8) in Form einer Schlaufe (12) des abgewickelten Lötbandes (1),
b) Ergreifen des Bandes (1) aus dem Bandpuffer (8) an einem Ende und Ziehen des Bandendes mit einer vorgegebenen Zugkraft (FZ) **durch** die von einer Vorschubeinheit (19) in Bandlaufrichtung (LR) verfahrbare Greifeinrichtung (20) bis zu einer Endposition entgegen einer **durch** die Bremseinrichtung (4) auf das Band aufgebrachten Gegenkraft (FG),
c) kontinuierliches Messen der Zugkraft (FZ) während des Ziehens nach Schritt b) mit einer Kraftmesseinrichtung (2),
d) Weiterleitung der Messwerte an den Rechner (3) zur Auswertung der Zugkraft (FZ) und permanentes Einregeln der Bremseinrichtung (4) auf den vorwählbaren Sollwert der Gegenkraft (FG) während des Ziehens **durch** die Greifeinrichtung (20),
e) Klemmen des Bandes (1) mit einer Klemmeinrichtung, (15) sobald die Greifeinrichtung (20) ihre Endposition (P2) erreicht hat,
f) Abtrennen der Lötverbinder (18) **durch** Schneiden des Bandes (1) mit der Schneideinrichtung (17), wobei zeitgleich der Bandpuffer (8) gemäß Schritt a) aufgefüllt wird und Wiederholen der Schritte b) bis f).

3. Verfahren nach Anspruch 1 und 2, **dadurch gekennzeichnet, dass** durch die Wahl der Endposition (P2) der Greifeinrichtung (20) die Länge der Lötverbinder (18) frei regelbar ist.

4. Verfahren nach Anspruch 1 und 2, **dadurch gekennzeichnet, dass** der Sollwert der Gegenkraft (FG) der Bremseinrichtung (4) über den Rechner (3) frei einstellbar ist.

5. Verfahren nach Anspruch 1, **dadurch gekennzeichnet, dass** das Lötband (1) an einer Position geklemmt und durch Ziehen des Lötbandes (1) gegen die geklemmte Position unter permanenter Messung der Streckkraft solange gereckt wird, bis ein der Fließgrenze des Lötbandes (1) entsprechender Sollwert erreicht wird, wobei die Messwerte dem Rechner (3) zugeführt werden, der die Messwerte mit einem der Fließgrenze des Lötbandes (1) entsprechenden Söllwert vergleicht und bei Erreichen des Sollwertes die Schneideinrichtung (17) zum Abtrennen des Lötverbinders (18) ansteuert.

6. Verfahren nach Anspruch 5, **gekennzeichnet durch** folgende Schritte:
a) Ausbilden eines Bandpuffers (8) in Form einer Schlaufe (12) des abgewickelten Bandes (1),
b) Ergreifen des Bandendes aus dem Bandpuffer (8) **durch** die Greifeinrichtung (20) und Bewegen bis zu einer vorgegebenen Länge des Lötverbinders (18),
c) Klemmen des Bandes (1) mit einer Klemmeinrichtung, (15) sobald die Greifeinrichtung (20) die vorgewählte Länge erreicht hat,
d) Ziehen des geklemmten Lötbandes (1) in Richtung einer von der Vorschubeinheit (19) vorgegebenen Endposition (P2) mit der Greifeinrichtung (20) bis der Sollwert eine vorgegebene Streckkraft **durch** ein kontinuierliches Messen der Zugkraft (FZ) während des Ziehens mit der Kraftmesseinrichtung (2) detektiert wird,
e) Weiterleitung der Messwerte an den Rechner (3) zur Auswertung der Streckkraft und Ansteuern der Schneideinrichtung (17),
f) Abtrennen der Lötverbinder (18) **durch** Schneiden des Bandes (1) mit der Schneideinrichtung (17), wobei zeitgleich der Bandpuffer (8) gemäß Schritt a) aufgefüllt wird und Wiederholen der Schritte b) bis f).

7. Verfahren nach Anspruch 1 oder 6, **dadurch gekennzeichnet, dass** die Schlaufe (12) durch eine senkrecht zur Vorschubrichtung des Bandes (1) selbsttätig verfahrbare Abzugseinrichtung (7) gebildet wird.

8. Verfahren nach Anspruch 6, **dadurch gekennzeichnet, dass** die Schlaufe (12) durch eine senkrecht zur Vorschubrichtung des Bandes (1) wirkende Masse einer Tensoreinrichtung (22) entgegen einer auf das Band (1) einwirkenden Bremskraft (FG) gebildet wird, die in Abhängigkeit einer Minimal- oder Maximallage der Schlaufe (12) zu- oder abgeschaltet wird.

9. Vorrichtung zur Durchführung des Verfahrens nach Anspruch 1, mit einer Haspeleinrichtung (5) zum Auf- und Abwickeln von Lötband (1), einer Greifeinrichtung (20) zum Recken des Lötbandes (1) und einer Schneideinrichtung (17) zum Ablängen von Lötverbindern (18) vom Lötband (1), **dadurch gekennzeichnet, dass** eine als Bandpuffer (8) bzw. Schlaufe (12) ausgebildete, senkrecht zur Bandlaufrichtung (LR) verfahrbare Abzugseinrichtung (7) oder eine Tensoreinrichtung (22) vorgesehen ist, der eine Bremseinrichtung (4) zum Aufbringen einer Brems- bzw. Gegenkraft (FG) auf das Lötband (1), eine Klemmeinrichtung (15) zum Festhalten des Lötbandes (1), die Schneideinrichtung (17) zum Durchtrennen des Lötbandes (1) und die auf einer Vorschubeinheit (19) parallel zum Bandlauf verfahrbare Greifeinrichtung (20) zur Verfahren des Lötbandes aus einer der Schneideinrichtung (17) zugeordneten Position (P1) in eine die Länge der Lötverbinder bestimmende Endposition (P2) nachgeordnet sind, wobei die Greifeinrichtung (20) mit einer Messeinrichtung (2) zum Ermitteln einer zwischen Bremseinrichtung (4) und Greifeinrichtung (20) wirkenden Zugkraft (FZ) versehen ist, die mit einem Rechner (3) zum Ansteuern der Bremseinrichtung (4) zwecks Angleichung der Gegenkraft (FG) an einen vorgegebenen Sollwert einen Regelkreis (R1) bildet.

10. Vorrichtung zur Durchführung des Verfahrens nach Anspruch 1, mit einer Haspeleinrichtung (5) zum Auf- und Abwickeln von Lötband (1), einer Greifeinrichtung (20) zum Recken des Lötbandes (1) und einer Schneideinrichtung (17) zum Ablängen von Lötverbindern (18) vom Lötband (1), **dadurch gekennzeichnet, dass** eine als Bandpuffer (8) bzw. Schlaufe (12) ausgebildete, senkrecht zur Bandlaufrichtung (LR) verfahrbare Abzugseinrichtung (7) oder Tensoreinrichtung (22) vorgesehen ist, der eine Bremseinrichtung (4) zum Aufbringen einer Bremskraft auf das Lötband (1), eine Klemmeinrichtung (15) zum Festhalten des Lötbandes (1), die Schneideinrichtung (17) zum Durchtrennen des Lötbandes (1) und die auf einer Vorschubeinheit (19) parallel zum Bandlauf verfahrbare Greifeinrichtung (20) zur Verfahren des Lötbandes aus einer der Schneideinrichtung (17) zugeordneten Position (P1) in eine die Länge der Lötverbinder bestimmende Endposition (P2) nachgeordnet sind, wobei die Greifeinrichtung (20) mit einer Messeinrichtung (2) zum Ermitteln einer zwischen Klemmeinrichtung (16) und Greifeinrichtung (20) wirkenden Streckkraft versehen ist, die mit einem Rechner (3) zum Ansteuern der Schneideinrichtung (17) zwecks Abtrennen des Lötverbinders vom Lötband bei Erreichen eines vorgegebenen Sollwert der Streckkraft einen Regelkreis (R2) bildet.

11. Vorrichtung nach Anspruch 9, **dadurch gekennzeichnet, dass** die Bremseinrichtung (4) zueinander anstellbare Rollen (14) aufweist

12. Vorrichtung nach Anspruch 9 oder 10, **dadurch gekennzeichnet, dass** die Abzugseinrichtung (7) eine durch einen Linearantrieb (10) senkrecht zur Bandlaufrichtung (LR) verfahrbare Umlenkrolle (11) zum Ausbilden der Bandschlaufe (12) und stationäre Umlenkrollen (9,13) zum Umlenken des Lötbandes (1) umfasst.

13. Vorrichtung 9 oder 10, **dadurch gekennzeichnet, dass** die Tensoreinrichtung (22) eine senkrecht zur Bandlaufrichtung (LR) durch ihre Masse absenkbare Tensorrolle (23), eine der Haspeleinrichtung (5) zugeordnete Bremse (25), Sensoren (24) zum Erfassen einer Minimal- oder Maximallage der Schlaufe (12), ein Steuerorgan (26) zum Zu- oder Abschalten der Bremse (25) und stationäre Umlenkrollen (9,13) zum Umlenken des Lötbandes (1) umfasst.

14. Vorrichtung nach Anspruch 9 oder108, **dadurch gekennzeichnet, dass** die Vorschubeinheit (19) einen Linearantrieb zum Verfahren der Greifeinrichtung (20) aufweist.

15. Vorrichtung nach Anspruch 9 oder 10, **dadurch gekennzeichnet, dass** die Messeinrichtung (2) eine Kraftmessdose ist.

## Claims

1. A method for stretching a solder ribbon, in particular solder connectors (18) for solar cells, in which a thin solder ribbon (1) stored on a coiling device (5) is unwound, stretched and supplied to a cutting device (17) for cutting the solder connectors (18) to length, **characterised in that**, during the stretching process, the tensile force (FZ) of the solder ribbon (1) is permanently determined by a measurement device (2) and, using the determined measured values, a counterforce (FG) generated in a braking device (4) is continuously balanced by a computer (3) to a predetermined tensile force (FZ) setpoint value which is approximately or exactly adjusted to the yield point of the material type of the solder ribbon (1).

2. A method according to claim 1, **characterised by** the following steps:
a) forming a ribbon buffer (8) in the form of a loop (12) of the unwound solder ribbon (1),
b) gripping the ribbon (1) from the ribbon buffer (8) at one end and drawing the ribbon end with a predetermined tensile force (FZ) by the gripping device (20) displaceable by a feed unit (19) in the ribbon travel direction (LR) up to an end position against a counterforce (FG) applied to the ribbon by the braking device (4),
c) continuously measuring tensile force (FZ) with a force measurement device (2) during drawing according to step b),
d) forwarding the measured values to the computer (3) for evaluation of the tensile force (FZ) and permanently adjusting the braking device (4) to the preselectable counterforce (FG) setpoint value during drawing by the gripping device (20),
e) clamping the ribbon (1) with a clamping means (15) as soon as the gripping device (20) has reached its end position (P2),
f) severing the solder connectors (18) by cutting the ribbon (1) with the cutting device (17), wherein the ribbon buffer (8) is simultaneously replenished according to step a), and repeating steps b) to f).

3. A method according to claims 1 and 2, **characterised in that** by selecting the end position (P2) of the gripping device (20), the length of the solder connectors (18) is freely adjustable.

4. A method according to claims 1 and 2, **characterised in that** the counterforce (FG) setpoint value of the braking device (4) is freely adjustable via the computer (3).

5. A method according to claim 1, **characterised in that** the solder ribbon (1) is clamped at one position and stretched by drawing the solder ribbon (1) against the clamped position with permanent measurement of the stretching force until a setpoint value corresponding to the yield point of the solder ribbon (1) is reached, wherein the measured values are supplied to the computer (3) which compares the measured values with a setpoint value corresponding to the yield point of the solder ribbon (1) and, once the setpoint value is reached, actuates the cutting device (17) for severing the solder connector (18).

6. A method according to claim 5, **characterised by** the following steps:
a) forming a ribbon buffer (8) in the form of a loop (12) of the unwound ribbon (1),
b) gripping the end of the ribbon from the ribbon buffer (8) by the gripping device (20) and moving up to a predetermined length of the solder connector (18),
c) clamping the ribbon (1) with a clamping means (15) as soon as the gripping device (20) has reached the preselected length,
d) drawing the clamped solder ribbon (1) towards an end position (P2) predetermined by the feed unit (19) with the gripping device (20) until the setpoint value of a predetermined stretching force is detected by continuously measuring the tensile force (FZ) during drawing with the force measurement device (2),
e) forwarding the measured values to the computer (3) for evaluating the stretching force and actuating the cutting device (17),
f) severing the solder connectors (18) by cutting the ribbon (1) with the cutting device (17), wherein the ribbon buffer (8) is simultaneously replenished according to step a), and repeating steps b) to f).

7. A method according to claim 1 or 6, **characterised in that** the loop (12) is formed by a draw-off device (7) which is autonomously displaceable perpendicularly to the feed direction of the ribbon (1).

8. A method according to claim 6, **characterised in that** the loop (12) is formed by a mass of a tension device (22) acting perpendicularly to the feed direction of the ribbon (1) against a braking force (FG) acting on the ribbon (1), which braking force is activated or deactivated as a function of a minimum or maximum position of the loop (12).

9. A device for carrying out the method according to claim 1, comprising a coiling device (5) for winding and unwinding solder ribbon (1), a gripping device (20) for stretching the solder ribbon (1) and a cutting device (17) for cutting solder connectors (18) to length from the solder ribbon (1), **characterised in that** a draw-off device (7) taking the form of a ribbon buffer (8) or loop (12) displaceable perpendicularly to the ribbon travel direction (LR) or a tension device (22), is provided, downstream of which are arranged a braking device (4) for applying a braking force or counterforce (FG) to the solder ribbon (1), a clamping means (15) for fixing the solder ribbon (1), the cutting device (17) for severing the solder ribbon (1) and the gripping device (20) displaceable on a feed unit (19) parallel to ribbon travel for displacing the solder ribbon from a position (P1) assigned to the cutting device (17) to an end position (P2) which determines the length of the solder connectors, wherein the gripping device (20) is provided with a measurement device (2) for determining a tensile force (FZ) acting between braking device (4) and gripping device (20), which, with a computer (3) for actuating the braking device (4) for the purpose of balancing the counterforce (FG) against a predetermined setpoint value, forms a control circuit (R1).

10. A device for carrying out the method according to claim 1, with a coiling device (5) for winding and unwinding solder ribbon (1), a gripping device (20) for stretching the solder ribbon (1) and a cutting device (17) for cutting solder connectors (18) to length from the solder ribbon (1), **characterised in that** a draw-off device (7) taking the form of a ribbon buffer (8) or loop (12) displaceable perpendicularly to the ribbon travel direction (LR) or tension device (22), is provided, downstream of which are arranged a braking device (4) for applying a braking force to the solder ribbon (1), a clamping means (15) for fixing the solder ribbon (1), the cutting device (17) for severing the solder ribbon (1) and the gripping device (20) displaceable on a feed unit (19) parallel to ribbon travel for displacing the solder ribbon from a position (P1) assigned to the cutting device (17) to an end position (P2) which determines the length of the solder connectors, wherein the gripping device (20) is provided with a measurement device (2) for determining a stretching force acting between clamping means (16) and gripping device (20), which, with a computer (3) for actuating the cutting device (17) for the purpose of severing the solder connector from the solder ribbon when a predetermined setpoint value of the stretching force is reached, forms a control circuit (R2).

11. A device according to claim 9, **characterised in that** the braking device (4) comprises rollers (14) which can be set relative to one another.

12. A device according to claim 9 or 10, **characterised in that** the draw-off device (7) comprises a deflection roller (11) displaceable by a linear drive (10) perpendicularly to the ribbon travel direction (LR) for forming the ribbon loop (12) and stationary deflection rollers (9, 13) for deflecting the solder ribbon (1).

13. A device according to claim 9 or 10, **characterised in that** the tension device (22) comprises a tension roller (23) lowerable under its own mass perpendicularly to the ribbon travel direction (LR), a brake (25) assigned to the coiling device (5), sensors (24) for determining a minimum or maximum position of the loop (12), a control member (26) for activating or deactivating the brake (25) and stationary deflection rollers (9, 13) for deflecting the solder ribbon (1).

14. A device according to claim 9 or 10, **characterised in that** the feed unit (19) comprises a linear drive for displacing the gripping device (20).

15. A device according to claim 9 or 10, **characterised in that** the measurement device (2) is a force transducer.

## Revendications

1. Procédé d'étirage d'une bande de soudure, en particulier des connecteurs de soudure (18) pour des cellules solaires, dans lequel une bande de soudure mince (1) stockée sur un système de bobinage, est déroulée, étirée et amenée à un système de découpe (17) pour sectionner les connecteurs de soudure (18), **caractérisé en ce que** pendant le processus d'étirage la force de traction (FZ) de la bande de soudage (1) est déterminée en permanence par un système de mesure (2) et une force antagoniste (FG) générée dans un système de freinage (4) par un ordinateur (3) avec les valeurs de mesure déterminées est alignée en continu sur une valeur théorique prédéterminée de la force de traction (FZ), qui est ajustée approximativement ou exactement à la limite apparente d'élasticité du type de matière de la bande de soudure (1).

2. Procédé selon la revendication 1, **caractérisé par** les étapes suivantes :
a) réalisation d'un tampon de bande (8) en forme de boucle (12) de la bande de soudure (1) déroulée,
b) saisie de la bande (1) provenant du tampon de bande (8) à une extrémité et traction de l'extrémité de bande avec une force de traction (FZ) prédéterminée par le biais du système de saisie (20) déplaçable par une unité de poussée (19) dans la direction d'avancée de la bande (LR) jusqu'à une position finale à l'encontre d'une force antagoniste (FG) appliquée sur la bande par un système de freinage (4),
c) mesure continue de la force de traction (FZ) pendant la traction selon l'étape b) avec un système de mesure de force (2),
d) transmission des valeurs de mesure à l'ordinateur (3) pour évaluer la force de traction (FZ) et réglage permanent du système de freinage (4) sur la valeur théorique présélectionnable de la force antagoniste (FG) pendant la traction par le biais du système de saisie (20),
e) serrage de la bande (1) avec un système de serrage (15) dès que le système de saisie (20) a atteint sa position finale (P2),
f) séparation des connecteurs de soudure (18) par découpe de la bande (1) avec le système de découpe (17), le tampon de bande (8) étant en même temps rempli conformément à l'étape a) et répétition des étapes b) à f).

3. Procédé selon la revendication 1 et 2, **caractérisé en ce que** la sélection de la position finale (P2) du système de saisie (20) permet de régler librement la longueur des connecteurs de soudure (18).

4. Procédé selon la revendication 1 et 2, **caractérisé en ce que** la valeur théorique de la force antagoniste (FG) du système de freinage (4) est ajustable librement via l'ordinateur (3).

5. Procédé selon la revendication 1, **caractérisé en ce que** la bande de soudure (1) est serrée dans une position et est étirée par serrage de la bande de soudure (1) contre la position serrée en mesurant en permanence la force d'étirage jusqu'à ce qu'une valeur théorique correspondant à la limite apparente d'élasticité de la bande de soudure (1) ait été atteinte, les valeurs de mesure étant transmises à l'ordinateur (3), qui compare les valeurs de mesure à une valeur théorique correspondant à une limite apparente d'élasticité de la bande de soudure (1) et, lorsque la valeur théorique est atteinte, commande le système de découpe (17) pour la séparation du connecteur de soudure (18).

6. Procédé selon la revendication 5, **caractérisé par** les étapes suivantes :
a) réalisation d'un tampon de bande (8) en forme de boucle (12) de la bande de soudure (1) déroulée,
b) saisie de la bande (1) provenant du tampon de bande (8) par le système de saisie (20) et déplacement jusqu'à une longueur prédéterminée du connecteur de soudure (18),
c) serrage de la bande (1) avec un système de serrage (15) dès que le système de saisie (20) a atteint la longueur présélectionnée,
d) traction de la bande de soudure (1) serrée dans la direction d'une position finale (P2) prédéterminée par l'unité de poussée (19) avec le système de saisie (20) jusqu'à ce que la valeur théorique d'une force d'étirage soit détectée par une mesure continue de la force de traction (FZ) pendant la traction avec le système de mesure de force (2),
e) transmission des valeurs de mesure à l'ordinateur (3) pour évaluer la force d'étirage et commande du système de découpe (17),
f) séparation des connecteurs de soudure (18) par découpe de la bande (1) avec le système de découpe (17), le tampon de bande (8) étant en même temps rempli conformément à l'étape a) et répétition des étapes b) à f).

7. Procédé selon la revendication 1 ou 6, **caractérisé en ce que** la boucle (12) est formée par un système de convoyage (7) déplaçable de manière autonome perpendiculairement à la direction de poussée de la bande (1).

8. Procédé selon la revendication 6, **caractérisé en ce que** la boucle (12) est formée par une masse, agissant perpendiculairement à la direction de poussée de la bande (1), d'un système tenseur (22) contre une force de freinage (FG) agissant sur la bande (1), qui est initiée ou arrêtée en fonction d'une position minimale ou maximale de la boucle (12).

9. Dispositif de réalisation du procédé selon la revendication 1, comprenant un système de bobinage (5) pour enrouler et dérouler la bande de soudure (1), un système de saisie (20) pour étirer la bande de soudure (1) et un dispositif de découpe (17) pour sectionner les connecteurs de soudure (18) de la bande de soudure (1), **caractérisé en ce qu'**un système de convoyage (7), déplaçable perpendiculairement à la direction d'avancée de la bande (LR) configuré en tant que tampon de bande (8) ou boucle (12), ou un système tenseur (22) est prévu, auquel sont subordonnés un système de freinage (4) pour appliquer une force de freinage ou une force antagoniste (FG) sur la bande de soudure (1), un système de serrage (15) pour maintenir la bande de soudure (1), le dispositif de découpe (17) pour sectionner la bande de soudure (1) et le système de saisie (20) déplaçable sur une unité de poussée (19) parallèlement à l'avancée de la bande pour déplacer la bande de soudure depuis une position (P1) associée au dispositif de découpe (17) jusque dans une position finale (P2) définissant la longueur des connecteurs de soudure, le système de saisie (20) étant pourvu d'un système de mesure (2) pour déterminer une force de traction (FZ) agissant entre le système de freinage (4) et le système de saisie (20), qui forme avec un ordinateur (3) pour commander le système de freinage (4), en vue de l'alignement de la force antagoniste (FG) sur une valeur théorique prédéterminée, une boucle d'asservissement (R1).

10. Dispositif de réalisation du procédé selon la revendication 1, comprenant un système de bobinage (5) pour enrouler et dérouler la bande de soudure (1), un système de saisie (20) pour étirer la bande de soudure (1) et un système de découpe (17) pour sectionner les connecteurs de soudure (18) de la bande de soudure (1), **caractérisé en ce qu'**un système de convoyage (7), déplaçable perpendiculairement à la direction d'avancée de la bande (LR) configuré en tant que tampon de bande (8) ou boucle (12), ou un système tenseur (22) est prévu, auquel sont subordonnés un système de freinage (4) pour appliquer une force de freinage sur la bande de soudure (1), un système de serrage (15) pour maintenir la bande de soudure (1), le dispositif de découpe (17) pour sectionner la bande de soudure (1) et le système de saisie (20) déplaçable sur une unité de poussée (19) parallèlement à l'avancée de la bande pour déplacer la bande de soudure depuis une position (P1) associée au dispositif de découpe (17) jusque dans une position finale (P2) définissant la longueur des connecteurs de soudure, le système de saisie (20) étant pourvu d'un système de mesure (2) pour déterminer une force de traction agissant entre le système de serrage (16) et le système de saisie (20), qui forme avec un ordinateur (3) pour commander le système de découpe (17), en vue de la séparation du connecteur de soudure de la bande de soudure lorsqu'une valeur théorique prédéterminée de la force d'étirage est atteinte, une boucle d'asservissement (R2).

11. Dispositif selon la revendication 9, **caractérisé en ce que** le système de freinage (4) présente des cylindres (14) réglables entre eux.

12. Dispositif selon la revendication 9 ou 10, **caractérisé en ce que** le système de convoyage (7) comprend un cylindre de déviation (11) déplaçable par un mécanisme d'entraînement linéaire (10) perpendiculairement à la direction d'avancée de la bande (LR) pour réaliser la boucle de bande (12) et des cylindres de déviation fixes (9, 13) pour dévier la bande de soudure (1).

13. Dispositif selon la revendication 9 ou 10, **caractérisé en ce que** le système tenseur (22) comprend un rouleau tenseur (23) abaissable par sa masse perpendiculairement à la direction d'avancée de la bande (LR), un frein (25) associé au système de bobinage (5), des capteurs (24) pour détecter une position minimale ou maximale de la boucle (12), un organe de commande (26) pour initier ou arrêter le freinage (25) et des cylindres de déviation fixes (9, 13) pour dévier la bande de soudure (1).

14. Dispositif selon la revendication 9 ou 10, **caractérisé en ce que** l'unité de poussée (19) présente un mécanisme d'entraînement linéaire pour déplacer le système de saisie (20).

15. Dispositif selon la revendication 9 ou 10, **caractérisé en ce que** le système de mesure (2) est une boîte dynamométrique.
